# EUROPEAN PATENT APPLICATION

(11) **EP 4 408 016 A1**
(43) Date of publication of application: **31.07.2024**
(21) Application number: 23153777.0
(22) Date of filing: 27.01.2023
(51) Int. Cl.: H04R 1/08, H04R 31/00, H04R 19/00, B81B 7/00, H04R 1/44, H04R 17/02, H04R 19/04

(54) **MEMS DEVICE WITH MEMBRANE COMPRISING UPRIGHT NANOSTRUCTURES AND METHOD FOR MANUFACTURING SAME**

(71) Applicant: Infineon Technologies AG, 85579 Neubiberg (DE)
(72) Inventor: WASISTO, Hutomo Suryo, 81541 München (DE); ANZINGER, Sebastian, 83714 Miesbach (DE); STREB, Fabian, 93059 Regensburg (DE)
(74) Representative: Hersina, Günter

(57) **Abstract**

This disclosure concerns a MEMS - microelectromechanical system - device (100) comprising a substrate (110) comprising a vertically extending through hole (120) and a horizontally extending membrane structure (130) covering the through hole (120), wherein the membrane structure (130) comprises a plurality of upright nanostructures (150) for providing a liquid repellent membrane surface. This disclosure further concerns methods for fabricating such MEMS devices (100).

## Description

### GENERAL DESCRIPTION

Embodiments of the present disclosure relate to a MEMS device (MEMS: microelectromechanical system) comprising a membrane with a liquid repellent membrane surface, wherein the membrane has at least one of oleophobic and hydrophobic characteristics.

### TECHNICAL BACKGROUND

MEMS-based systems are miniaturized systems that comprise a very small form factor. For example, pressure transducers may be provided as MEMS devices, wherein a small membrane may transduce mechanical oscillations of the membrane into electric signals, or vice versa. An example of a MEMS pressure transducer may be a tire pressure sensor that monitors air pressure in tires. A further example may be a MEMS microphone that transduces sound waves (as an example of air pressure), such as music or voice, into electric signals, which can then be converted into digital data. In the reverse direction, a MEMS speaker may convert digital data into sound by oscillating the membrane.

Due to their miniaturized size, MEMS pressure transducers require environmental protection because they can be influenced by several environmental ingress from the surrounding environment, for instance dust particles, water and moisture, which can then lead to lower robustness level and shorter operation time.

For example, currently available MEMS-based microphones often have failures when they are exposed to liquids, for example water droplets, salt-containing liquids, sweat or oil. In case water droplets containing conductive particles, such as salts, reach the MEMS microphone membrane via the bottom sound port, these particles can remain on the bottom membrane surface when the water has evaporated, which may often result in device contamination, corrosion and/or electrical shortcut (leakage). If this phenomenon occurs over a long time, the device may not work as it should, leading to lower robustness and shorter lifetime.

The bottom membranes of MEMS microphones typically possess planar surfaces comprising hydrophilic characteristic, which is typical for planar silicon surfaces. Thus, droplets of water or other liquids tend to adsorb onto the membrane surface. After the liquids have evaporated, solid materials (e.g., salts, particles, and other contaminants) that were contained in said evaporated liquids may remain on the membrane.

The commonly implemented solution to protect the membranes of MEMS microphones is by adding external discrete environmental barrier (EB) components, e.g., an EB membrane having hydrophobic / oleophobic characteristics, and which is placed either inside or outside the package lid covering the sound port. This solution has, however, some drawbacks, such as high production cost, large package size, low acoustic performance, and limited usage for applications.

Therefore, it would be desirable to provide a MEMS device with a membrane comprising a liquid repellent membrane surface and an inherent oleophobic and/or hydrophobic characteristic without the above mentioned drawbacks.

This can be achieved by means of the herein disclosed MEMS device and the corresponding methods for fabricating the MEMS device according to the independent claims. Further embodiments and advantageous aspects are suggested in the dependent claims.

One aspect concerns a MEMS device comprising a substrate comprising a vertically extending through hole and a horizontally extending membrane structure covering the through hole, wherein the membrane structure comprises a plurality of upright nanostructures for providing a liquid repellent membrane surface.

A further aspect concerns a method for fabricating a MEMS device, the method comprising a step of providing a substrate comprising a first substrate surface and an opposite second substrate surface, wherein the substrate comprises a sacrificial layer arranged at the first substrate surface. The method further comprises a step of structuring nanoimprints into the sacrificial layer, and filling the nanoimprints by depositing a first material onto the structured sacrificial layer. The method further comprises a step of structuring a cavity into the substrate, the cavity being positioned opposite the filled nanoimprints and extending between the second substrate surface and the sacrificial layer. The method further comprises a step of releasing the filled nanoimprints by removing the sacrificial layer through the cavity, thereby creating a horizontally extending membrane comprising upright nanostructures that extend into the cavity.

Yet a further aspect concerns a method for fabricating a MEMS device, the method comprising steps of providing a substrate having a first substrate surface and an opposite second substrate surface, and creating upright nanostructures in the first substrate surface. The method further comprises a step of structuring a cavity into the substrate, the cavity being positioned opposite the upright nanostructures and extending from the second substrate surface up to a remaining substrate portion left between the cavity and the upright nanostructures, thereby creating a membrane structure horizontally extending over the cavity and having the upright nanostructures integrated therein, wherein the upright nanostructures face away from the cavity.

In the following, embodiments of the present disclosure are described in more detail with reference to the figures, in which
- Fig. 1A: shows a schematic cut perspective view of a MEMS device according to an embodiment being configured as a discrete environmental barrier,
- Fig. 1B: shows a schematic side view of the MEMS device of Figure 1A,
- Fig. 2A: shows a schematic cut perspective view of a MEMS device according to an embodiment being configured as a MEMS-based single backplate microphone,
- Fig. 2B: shows a schematic side view of the MEMS device of Figure 2A,
- Fig. 3A: shows a schematic cut perspective view of a MEMS device according to an embodiment being configured as a MEMS-based sealed dual-membrane microphone,
- Fig. 3B: shows a schematic side view of the MEMS device of Figure 3A,
- Fig. 4: shows a schematic perspective view of upright three-dimensional nanostructures to be used in combination with a membrane structure according to an embodiment,
- Fig. 5: shows a schematic perspective view of some further upright three-dimensional nanostructures to be used in combination with a membrane structure according to an embodiment,
- Fig. 6: shows a schematic perspective view of some further upright three-dimensional nanostructures to be used in combination with a membrane structure according to an embodiment,
- Figs. 7A-7E: show schematic side views of different geometrical shapes of upright nanostructures to be used in combination with a membrane structure according to different embodiments,
- Fig. 8: shows a schematic side view of upright three-dimensional nanostructures being coated with an organic self-assembled monolayer according to an embodiment,
- Fig. 9: shows a schematic side view of upright three-dimensional nanostructures being decorated with nanowires according to an embodiment,
- Fig. 10A: shows a schematic side view of a MEMS-based package according to an embodiment, wherein the package comprises a MEMS device according to an embodiment, the MEMS device being configured as a MEMS-based single backplate microphone,
- Fig. 10B: shows a schematic side view of a MEMS-based package according to an embodiment, wherein the package comprises a MEMS device according to an embodiment, the MEMS device being configured as a MEMS-based sealed dual membrane microphone,
- Fig. 10C: shows a schematic side view of a MEMS-based package according to an embodiment, wherein the package comprises a MEMS device according to an embodiment, the MEMS device being configured as a MEMS-based discrete environmental barrier,
- Figs. 11A-11F: show method steps of a method for fabricating a MEMS device according to an embodiment, wherein the horizontally extending membrane structure and the upright nanostructures are made from the same material,
- Figs. 12A-12F: show method steps of a method for fabricating a MEMS device according to an embodiment, wherein the horizontally extending membrane structure and the upright nanostructures are made from different materials,
- Figs. 13A-13J: show method steps of a method for fabricating a MEMS device according to an embodiment, wherein the horizontally extending membrane structure and the upright nanostructures are directly structured into the substrate material, and
- Figs. 14A-14H: show method steps of a method for fabricating a MEMS device according to an embodiment, wherein the horizontally extending membrane structure is directly structured into the substrate material and wherein the upright nanostructures are grown on the substrate material.

### DESCRIPTION OF THE FIGURES

Equal or equivalent elements or elements with equal or equivalent functionality are denoted in the following description by equal or equivalent reference numerals.

Method steps which are depicted by means of a block diagram and which are described with reference to said block diagram may also be executed in an order different from the depicted and/or described order. Furthermore, method steps concerning a particular feature of a device may be replaceable with said feature of said device, and the other way around.

In the following description, a MEMS-based microphone will be mentioned as a non-limiting example for a MEMS device. However, other MEMS devices with a membrane structure comprising a plurality of upright nanostructures also fall under the scope of protection according to the herein described innovative concept.

Furthermore, terms like horizontally and vertically will be used in the following description. Of course, these terms are to be understood in relation to each other, but not necessarily in relation to the earth's horizon. Accordingly, the term horizontally may be synonymously used with "extending in a first direction / plane", while the term vertically may be synonymously used with "extending in a second direction / plane", the second direction / plane being perpendicular to the first direction / plane. For example, a substrate may comprise a primary extension direction, which may also be referred to as the substrate plane. For example, the term "horizontally" is to be understood as "parallel to the substrate plane" or "in plane", while the term "vertically" is to be understood as "perpendicular to the substrate plane".

Furthermore, upright nanostructures may be described, wherein said upright nanostructures may be arranged on a membrane structure. The term "upright" means that the nanostructures may extend away from the membrane structure, for example in an upward direction. For example, if the membrane structure may extend horizontally, the nanostructures may extend substantially vertically from the membrane structure. Whenever the term "vertically extending" is used in the present disclosure, it is within the scope of the present disclosure that the nanostructures may not be perfectly vertical, but that the nanostructures may be slightly tilted. For example, the terms "upright" and "vertically extending" may include that the nanostructures may be skew and may extend away from the membrane structure in an angle of 90° ±25°. Furthermore, some embodiments refer to a plurality of nanostructures that may be arranged, for instance, in a nanostructure array. Accordingly, the present disclosure always refers to a majority (i.e. at least 50%) of the nanostructures. For example, if the present disclosure mentions that "the" nanostructures are upright, it means that at least 50% of the nanostructures are upright. In real life, it may be possible that several hundreds or thousands of nanostructures may be present, wherein most of them are upright, e.g., substantially vertical, while a few percent of them may not be upright (less than 75° or more than 115°). Furthermore, some embodiments may describe horizontally extending membrane structures as non-limiting examples for membrane structures in general. In such embodiments, vertically extending nanostructures may be described as non-limiting examples of upright nanostructures. Accordingly, the terms "vertically extending" and "upright" may be used synonymously in the present disclosure.

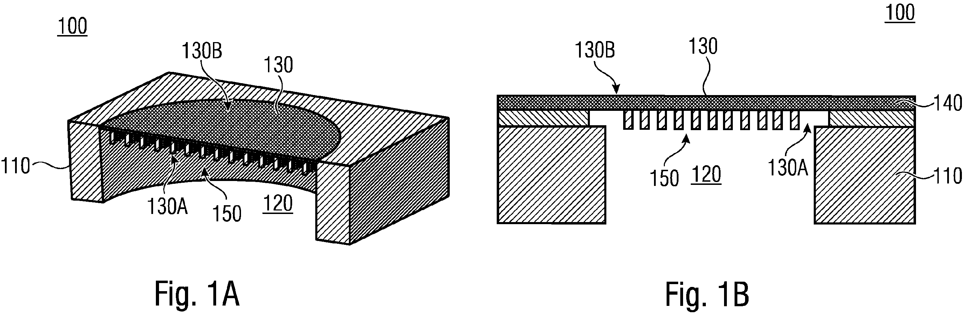

Figures 1A and 1B show a first embodiment of a MEMS device 100 according to the herein described innovative concept. The MEMS device 100 comprises a substrate 110. For example, the substrate 110 may comprise or be made from silicon. The substrate 110 comprises a vertically extending through hole 120. The through hole 120 may extend completely through the substrate 110.

The MEMS device 100 further comprises a horizontally extending membrane structure 130. For example, the membrane structure 130 may comprise or be made from polysilicon. The membrane structure 130 covers the vertically extending through hole 120. As will be described in more detail below, the membrane structure 130 may be created using a sacrificial layer 140 (e.g., TEOS: tetraethoxysilane or tetraethyl orthosilicate), wherein the sacrificial layer 140 may connect the membrane structure 130 with the substrate 110. Alternatively, the membrane structure 130 may be adhered to the substrate 110, e.g., by means of an adhesive.

According to the present innovative concept, the membrane structure 130 comprises a plurality of upright (e.g., vertically extending) nanostructures 150. In particular, the horizontally extending membrane structure 130 comprises a first membrane surface 130A facing the through hole 120, and an opposite second membrane surface 130B facing away from the through hole 120. As exemplarily depicted in Figures 1A and 1B, the upright nanostructures 150 may be arranged on the first membrane surface 130A. Additionally or alternatively, the upright nanostructures 150 may be arranged on the second membrane surface 130B. This holds for each and every embodiment as discussed herein.

The nanostructures 150 may extend substantially perpendicular to the membrane structure 130. The nanostructures 150 provide for a self-cleaning surface characteristic exploiting the so-called lotus effect. Accordingly, the nanostructures 150 provide for a liquid repellent membrane surface of the membrane structure 130. In particular, the nanostructures 150 provide for at least one of hydrophobic or oleophobic surface characteristics of the membrane structure 130.

In contrast, a membrane without these nanostructures 150 may comprise a hydrophilic surface characteristic, i.e., liquids (water, oil, etc.) adhere to the membrane. If the liquid evaporates, solid matters (like salts, particles, and other contaminants) that are solved in said liquids, may remain on the membrane surface which may often result in device contamination, corrosion and/or electrical shortcut (leakage). The membrane structure 130 of the herein described innovative concept, instead, comprises a hydrophobic and/or oleophobic surface characteristic, i.e., liquids (water, oil, etc.) are repelled from the membrane structure 130. Said hydrophobic and/or oleophobic surface characteristics are provided by the upright nanostructures 150.

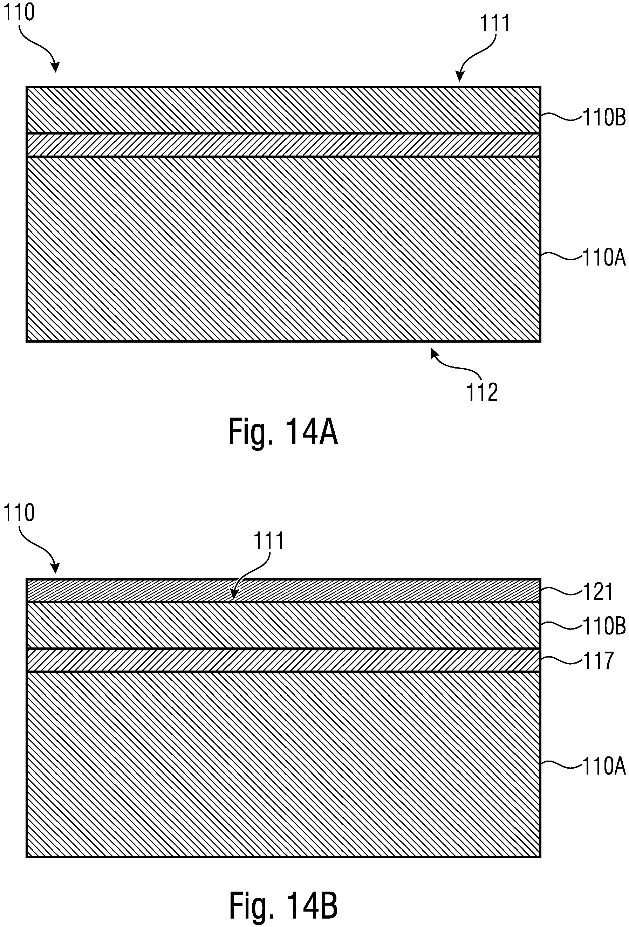

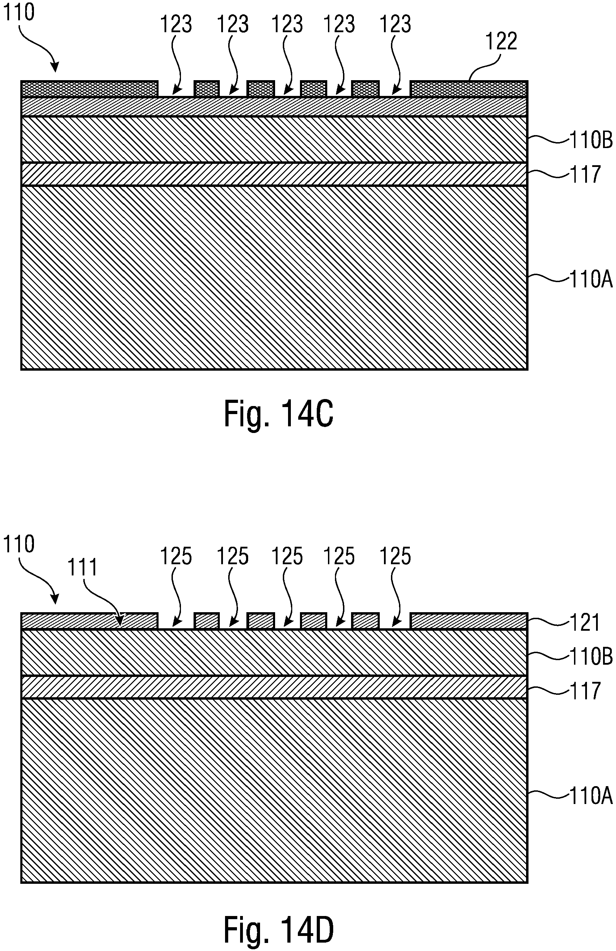

The MEMS device 100 as depicted in Figures 1A and 1B may be configured as a discrete environmental barrier structure, e.g., an environmental barrier mesh or membrane. Such environmental barrier structures 100 may be used in connection with MEMS microphones in order to protect the thin and fragile microphone membrane from ingress of environmental particles, moisture and other physical and/or chemical objects. Details will be discussed later with reference to Figure 14C.

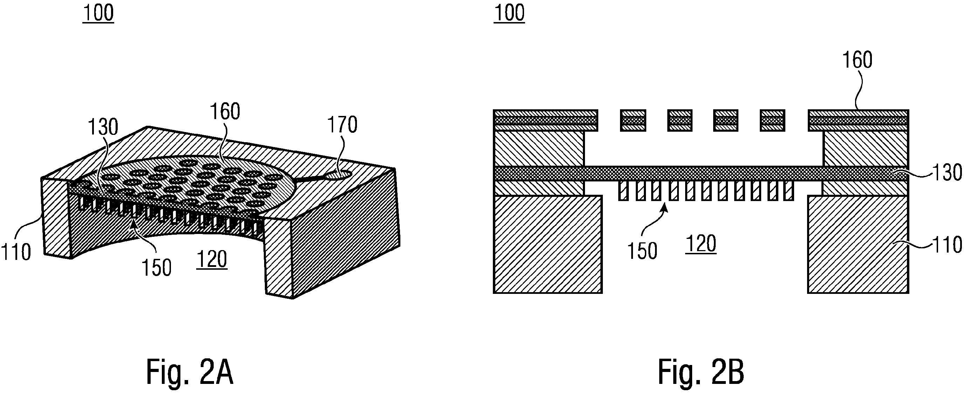

Figures 2A and 2B show a further embodiment of a MEMS device 100. In this non-limiting example, a so-called single backplate (SBP) MEMS-based microphone 100 is shown. In addition to the embodiment discussed above with reference to Figures 1A and 1B, the single backplate microphone 100 comprises an electrode structure 160 that can be electrically connected, e.g., by means of pads / terminals 170, to a circuitry (not shown). For example, the electrode structure 160 may comprise or be made from silicon nitride, Si₃N₄.

The previously described membrane structure 130 may be configured as a microphone membrane that can oscillate in response to acoustic waves. The acoustic waves may enter the microphone package through a so-called sound port. The depicted single backplate microphone 100 may be mounted over the sound port, such that the acoustic waves may enter the vertically extending through hole 120 and arrive at the bottom surface of the membrane structure 130.

As mentioned above, the upright (e.g., vertically extending) nanostructures 150 provide for a hydrophobic / oleophobic surface characteristic of the membrane structure 130. Thus, liquids contained in the air that is transferred by the acoustic waves may be repelled from the hydrophobic and/or oleophobic membrane surface. Accordingly, it is advantageous if the nanostructures 150 are provided at a membrane surface that faces a source of environmental liquids, for example the sound port. Thus, in this non-limiting example, the nanostructures 150 face the through hole 120 and vertically extend into the through hole 120. However, as will be explained below, the nanostructures 150 may additionally or alternatively face away from the through hole 120 and may vertically extend away from the through hole 120. In other words, the nanostructures 150 may be arranged on either one of the two membrane surfaces 130A, 130B or on both membrane surfaces 130A, 130B.

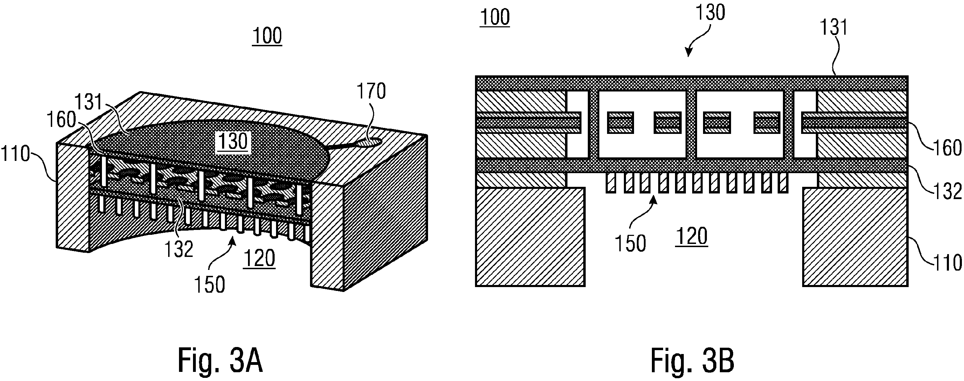

Figures 3A and 3B show a further embodiment of a MEMS device 100. In this non-limiting example, a so-called sealed dual-membrane (SDM) MEMS-based microphone 100 is shown. In addition to the embodiments discussed above, the sealed dual-membrane microphone 100 comprises a membrane structure 130 having a first membrane portion 131 and a second membrane portion 132. An electrode structure 160 is sandwiched between the first and second membrane portions 131, 132. While the membrane portions 131, 132 may be flexible, the electrode structure 160 may be a rigid electrode structure, such as a backplate or a stator, for example.

At least one of the first and second membrane portions 131, 132 may comprise the above described upright nanostructures 150. Also in this case, it is advantageous if the nanostructures 150 are provided at a membrane surface that faces a source of environmental liquids, for example the sound port. Thus, in this non-limiting example, the nanostructures 150 may be arranged on the second membrane portion 132 facing the through hole 120.

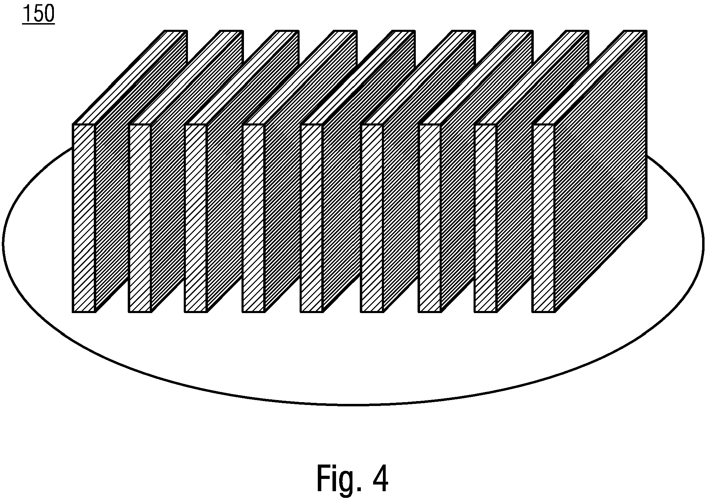

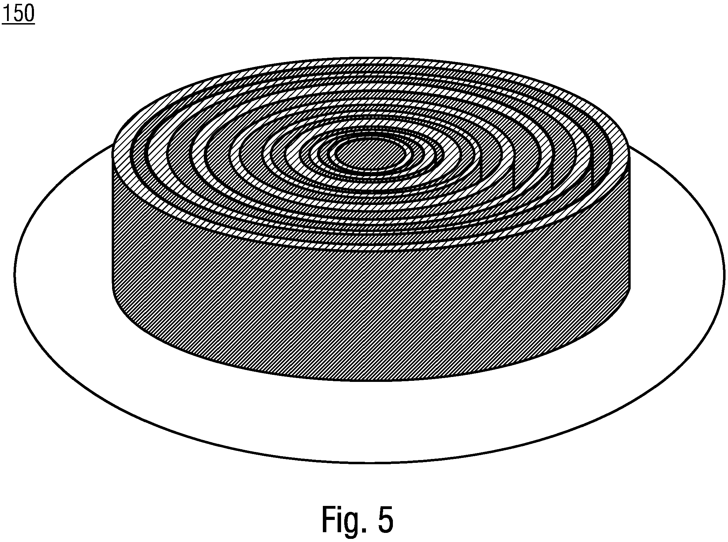

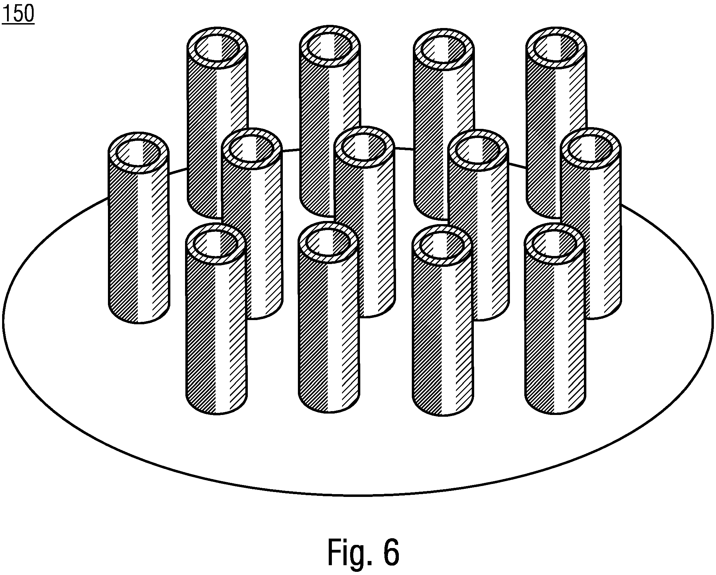

The nanostructures 150 may be configured as upright (e.g., vertically extending) nanospikes, nanotubes, nanofins, nanopillars, nanowhiskers, nanowalls, nanocircular walls, black silicon, and many more, while various other geometric designs and shapes are possible. Figures 4 to 6 show some non-limiting examples. Figure 4 shows upright nanostructures 150 being configured as upright walls or plates being consecutively arranged along a (straight or curved) line. Figure 5 shows upright nanostructures 150 being configured as concentric walls. Figure 6 shows upright nanostructures 150 being configured as (hollow) nanotubes.

Summarizing in a more general terminology, the upright nanostructures 150 may be configured as three-dimensional geometric structures extending away from the membrane structure 130. For example, the upright nanostructures 150 may extending into a direction that is substantially perpendicular to the lateral extension of the membrane structure 130.

For example, the nanostructures 150 may be configured as upright nanopillars extending away from a membrane structure 130. Nanopillars are pillar-shaped nanostructures, approximately a few nanometers (e.g. 10 nm to 1.000 nm) in diameter, that can be grouped together in lattice like arrays. In such an array configuration, the nanostructures 150 may be densely arranged next to each other. According to an embodiment, the plurality of nanostructures 150 may comprise an area density of 10⁶ - 10¹⁰ nanostructures per cm².

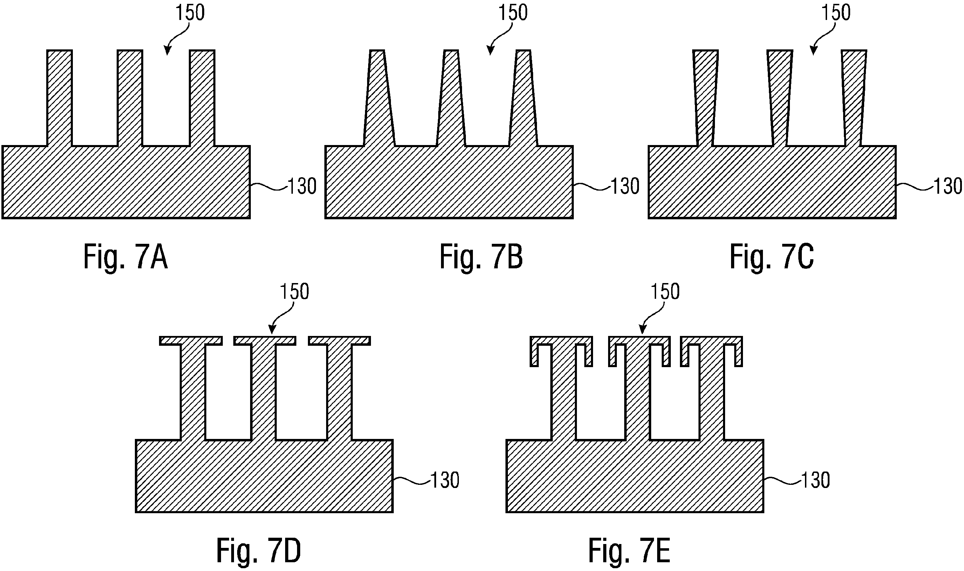

In some embodiments, the nanostructures 150 may comprise a geometrical shape similar to a frustum cone. However, various other geometrical shapes are possible, as exemplarily depicted in Figures 7A to 7E. As shown in Figure 7A, the upright nanostructures 150 may comprise a geometrical shape similar to a straight cylinder. As shown in Figure 7B, the upright nanostructures 150 may comprise a geometrical shape similar to a frustum cone. As shown in Figure 7C, the upright nanostructures 150 may comprise a geometrical shape similar to an inverted frustum cone. As shown in Figure 7D, the upright nanostructures 150 may comprise a T-shape, i.e., a geometrical shape similar to the letter 'T'. As shown in Figure 7E, the upright nanostructures 150 may comprise a multifaceted T-shape, i.e., a geometrical shape similar to the letter 'T' with additional contoured walls (e.g., reentrant structure). The different geometrical shapes may lead to different hydrophobic and/or oleophobic surface characteristics of the nanostructures 150.

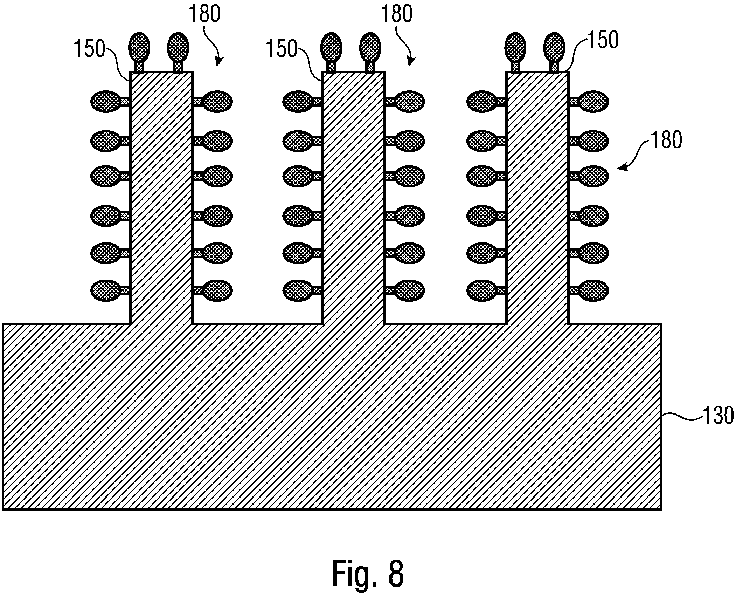

Besides different geometrical shapes, further advanced surface chemistry modification can be realized by introducing organic self-assembled monolayers, so-called SAMs. For example, Figure 8 shows an embodiment, wherein the upright nanostructures 150 may be coated with organic self-assembled monolayers. Nanostructures 150 being coated with SAMs exhibit an enhanced level of hydrophobicity and/or oleophobicity compared to uncoated nanostructures 150. Using this combined chemical/physical method, the SAM-coated nanostructures 150 can increase the resulting water or liquid contact angle on their surface and can repel not only water but also other liquids (e.g., oil) resulting in (super-)hydrophobic or omniphobic surfaces.

Different self-assembled monolayers, and in particular silane-based SAMs, may be used for coating the nanostructures 150. For example, the organic self-assembled monolayers may comprise, or may consist of, at least one of:
- Fluoroalkylsilanes (FAS),
- Perfluorodecyltrichlorosilane (FDTS),
- Heptadecafluoro-1,1,2,2-tetrahydrodecyltrichlorosilane (HDFS),
- Tridecafluoro-1,1,2,2-tetrahydrooctyltrichlorosilane (FOTS),
- Octadecyltrichlorsilane (ODTS),
- Methyltrimethoxysilane (MTMS),
- Bis(trimethylsilyl)amine or hexamethyldisilazane (HMDS),
- (3-Aminopropyl)triethoxysilane (APTES),
- Dichlorodimethylsilane (DDMS),
- Octadecyltrimethoxysilane (OTMS),
- Ethyltriethoxysilane (ETES), and
- 1H,1H,2H,2H-perfluorooctyltriethoxysilane (HFOTES).

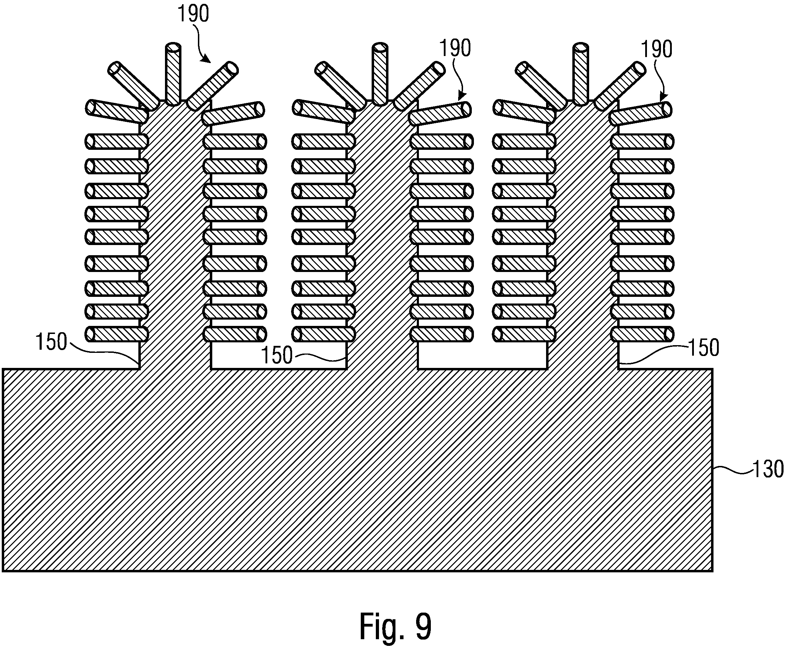

Figure 9 shows a further embodiment, wherein the nanostructures 150 may comprise inorganic nano-elements 190, e.g., nanodots or nanowires, extending away from a surface of the nanostructures 150. Nanostructures 150 comprising additional nano-elements 190 exhibit an enhanced level of hydrophobicity and/or oleophobicity compared to bare/naked nanostructures 150.

The inorganic nano-elements 190 may be grown on the surface of the nanostructures 150. For example, a suitable material, for example zinc oxide (ZnO), may be used for creating the nano-elements 190. For example, for creating ZnO nanowires, a zinc oxide film may be deposited onto the surface of the nanostructures 150 using e.g., a sputtering technique for forming ZnO nanoseeds. The growth of the ZnO nanowires can then be realized by employing e.g., a chemical bath deposition (CBD) process. Other alternative methods (e.g., hydrothermal method, vapor-liquid-solid process, spray pyrolysis, chemical vapor deposition, molecular beam epitaxy, electrodeposition, atomic layer deposition, and pulsed laser deposition) can also be opted to grow or deposit ZnO layer and create ZnO nanostructures. This combination with ZnO nanowires is beneficial for the case of coarse nanostructures 150 (e.g. nanostructures 150 with large pitch or distance among them). ZnO nano-elements 190 may be advantageously grown on silicon-based nanostructures 150.

In result, the grown nano-elements 190 may extend substantially perpendicular from the surface of the nanostructures 150. Accordingly, the nanostructures 150 may comprise a tree-like shape. Each of the tree-like nanostructures 150 may comprise a plurality of inorganic nano-elements 190, e.g., nanowires.

As mentioned above, the upright nanostructures 150 may provide a hydrophobic and/or oleophobic and/or superhydrophobic and/or omniphobic surface characteristic of the membrane structure 130. To explain these surface characteristics, imagine an untreated planar silicon surface on which a water droplet is applied. Planar silicon surfaces in general comprise a hydrophilic surface characteristic, i.e., liquids are adhered to the planar surface due to its low surface roughness and, thus, its large surface energy. A hydrophilic surface comprises a small water contact angle. For example, the water contact angle may be around 5° to 20°.

In turn, a nanostructured silicon surface, for example the herein described membrane structure 130 with the upright nanostructures 150, may comprise a larger water contact angle of greater than 150°. Therefore, a water droplet being applied to the nanostructured surface almost stays in a perfect sphere shape. This is due to the higher surface roughness and, thus, lower surface energy provided by the nanostructures 150. Accordingly, the membrane structure 130 comprising the nanostructures 150 may comprise a hydrophobic or even superhydrophobic surface characteristic.

Superhydrophobic surfaces generally show water contact angles of greater than 150° (nearly perfect sphere) along with low contact angle hysteresis. Contact angle hysteresis is defined as the difference between measured values of the advancing and receding contact angles (the highest and lowest contact angles on such a structures).

Additionally or alternatively, the nanostructures 150 applied on the membrane structure 130 may provide an oleophobic surface characteristic such that oils are repelled from the membrane surface, or even an omniphobic surface characteristic such that almost each and every liquid is repelled from the membrane surface.

Liquids that approach the nanostructured membrane 130 having superhydrophobic/omniphobic surface characteristics will bounce or roll off. Hence, the herein discussed nanostructures 150 are useful for water/liquid repellent and self-cleaning surfaces. The nanostructured membrane surface can be self-cleaning because any water/liquid droplets that contact it will roll off picking up any particles along with the operation of the moving membrane 130.

By adjusting the geometry (e.g., diameter, height, aspect ratio, pitch) of the nanostructures 150, the hydrophobicity / oleophobicity / omniphobicity level of the nanostructures 150 can be varied.

According to some embodiments, the upright nanostructures 150 may comprise a diameter of 1 µm or less. If the nanostructures 150 may comprise a varying diameter, e.g., if they were configured as frustum cones, the diameter is measured at the thickest portion. Additionally or alternatively, the upright nanostructures 150 may comprise a pitch, i.e., a distance between the centers of two adjacent nanostructures 150, said pitch comprising a ratio of at least pitch : diameter = 2:1. Additionally or alternatively, the upright nanostructures 150 may comprise an aspect ratio (width-to-height) between 1:3 and 1:40. The authors of this disclosure have found that nanostructures 150 with high aspect ratio (e.g., x > 5) produce a larger contact angle (more hydrophobicity / omniphobicity) than those with low aspect ratio (e.g., 1 < x < 5).

As mentioned above with reference to Figures 1A to 3B, the MEMS device 100 may be configured as a MEMS-based microphone or as a discrete MEMS-based environmental barrier. The MEMS device 100 may be housed underneath a lid so as to produce a MEMS-based package, e.g., a microphone package.

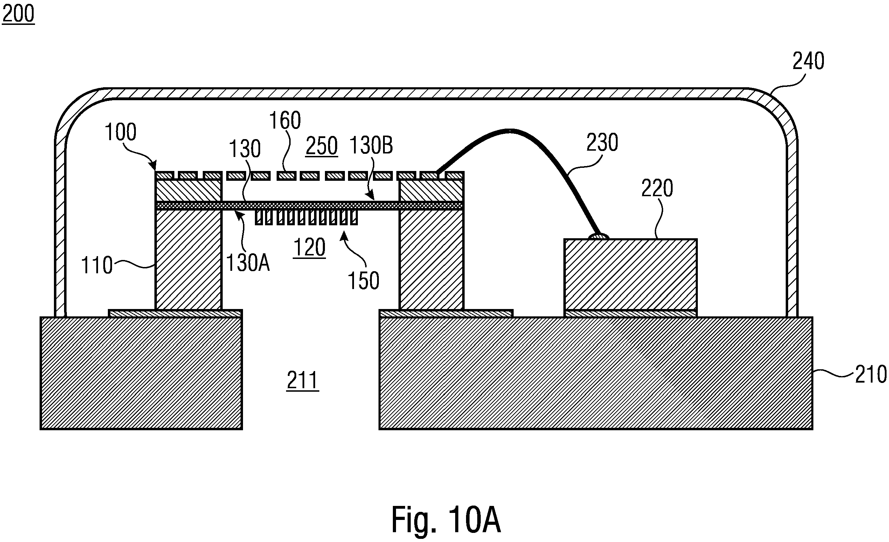

Figure 10A shows a first embodiment of a MEMS-based package 200. The package 200 comprises a component board 210, e.g., a printed circuit board (PCB). A MEMS device 100 according to the herein described innovative concept is arranged on the component board 210. A circuitry 220 for controlling the MEMS device 100 may be arranged adjacent to the MEMS device 100. The MEMS device 100 may be electrically connected to the circuitry 220, for example by means of a bond wire 230.

The package 200 may further comprise a lid 240 being arranged on the component board 210. The lid 240 may cover the MEMS device 100 and the circuitry 220. The free space or cavity 250 underneath the hollow lid 240 may provide for an acoustic back volume.

The component board 210 may comprise a vertically extending through hole 211. In case the MEMS-based package 200 is a microphone package (as exemplarily depicted here), the through hole 211 may be referred to as a sound port through which acoustic waves may enter the cavity 250.

In this non-limiting example, the MEMS device 100 is configured as a MEMS-based single backplate (SBP) microphone, as previously discussed above with reference to Figures 2A and 2B. Here, the horizontally extending membrane structure 130 is configured as a microphone sound transducer membrane, wherein the upright nanostructures 150 are arranged at the microphone sound transducer membrane 130. In this example, the nanostructures 150 may be arranged on the first membrane surface 130A facing the through hole 120. However, additionally or alternatively, the nanostructures 150 may be arranged on the second membrane surface 130B facing away from the through hole 120. For any further details as to the single components belonging to said SBP microphone 100, it is referred to the discussion above.

As can be seen in Figure 10A, the SBP microphone 100 is arranged directly opposite to the sound port 211, e.g., above the sound port 211. The SBP microphone 100 is arranged such that it covers the sound port 211. When viewed from above, the horizontally extending membrane structure 130 circumferentially covers the sound port 211. In this non-limiting example, the upright nanostructures 150 face the sound port 211.

As mentioned above, acoustic waves may enter the package 200 through the sound port 211. Since the sound port 211 is in fluid connection with the through hole 120, the acoustic waves may be further conveyed into the through hole 120 until reaching the membrane structure 130. The membrane structure 130 will be deflected in response to the impinging acoustic waves. The amplitude of deflection will be measured by the electrode structure 160.

The air through which the acoustic waves may travel may comprise moisture, e.g., liquids containing salt particles and the like. Since the herein described innovative membrane structure 130 comprises the upright nanostructures 150, the membrane structure 130 shows a (super-)hydrophobic / omniphobic surface characteristic. Thus, intruding liquids and or any solid matter (like salts, particles, and other contaminants) contained in said liquids may be repelled from the surface of the membrane structure 130. This provides for a superior protection of the microphone membrane 130.

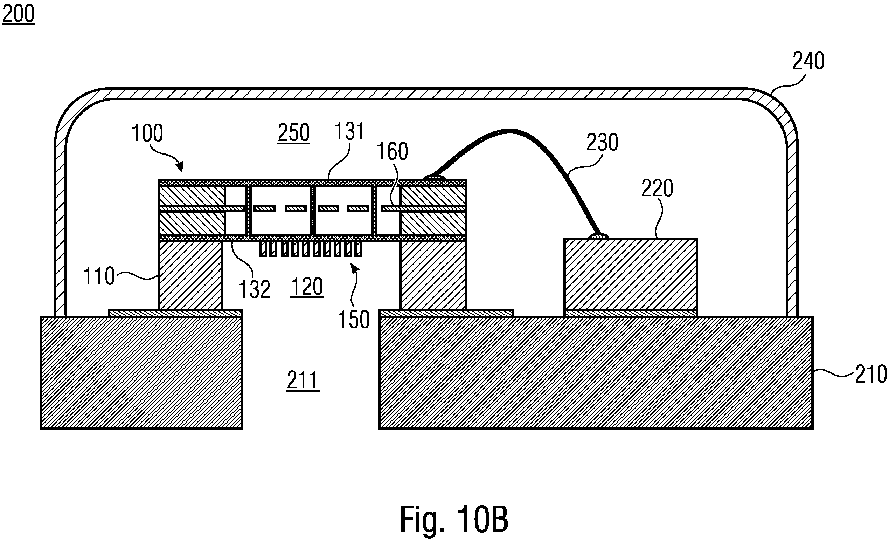

Figure 10B shows a further embodiment of a MEMS-based package 200 being configured as a microphone package. Like elements with like features, as discussed with reference to Figure 10A, are indicated with same reference numerals. Accordingly, for further details it is referred to the above discussion. A difference compared to the above discussed embodiment (c.f. Figure 10A) is the type of MEMS device 100 used. In this non-limiting example, the MEMS device 100 is configured as a sealed dual-membrane (SDM) MEMS-based microphone. Regarding technical details of the SDM microphone 100 it is referred to Figures 3A and 3B.

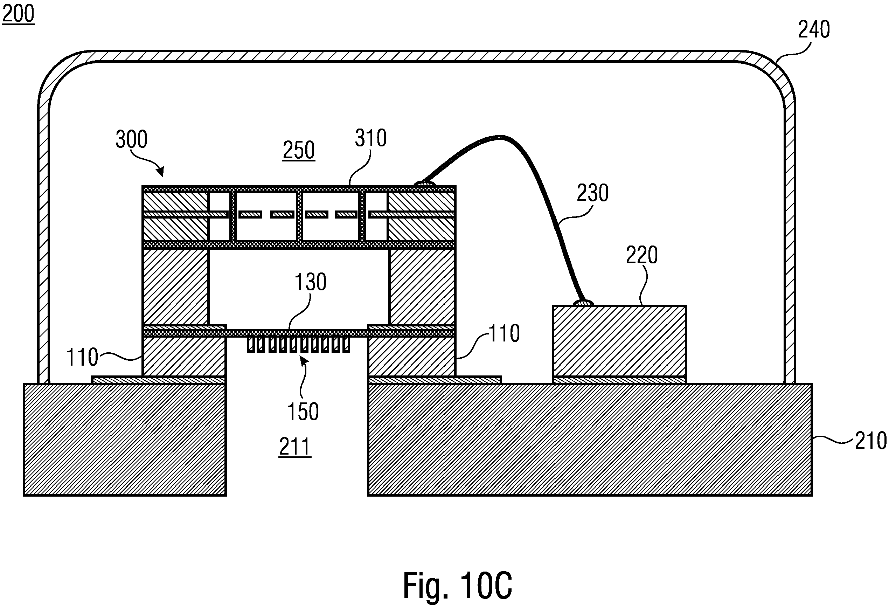

Figure 10C shows a further embodiment of a MEMS-based package 200. Again, like elements with like features, as discussed with reference to Figures 10A and 10B, are indicated with same reference numerals. In this non-limiting example, the MEMS device 100 according to the herein described innovative principle may be configured as a discrete MEMS-based environmental barrier structure. For details as to any elements comprised by said environmental barrier 100, it is referred to Figures 1A and 1B above.

Furthermore, a MEMS-based microphone 300 is depicted. This MEMS-based microphone 300 may be a MEMS device 100 as discussed above, or a conventional MEMS-based microphone. In this non-limiting example, a conventional SDM microphone is depicted. However, it may also be possible that a SBP microphone may be used instead. The MEMS-based microphone 300 may comprise a microphone sound transducer membrane 310.

As can be seen in Figure 10C, the MEMS device 100 is arranged between the sound port 211 and the MEMS-based microphone 300. Thus, the MEMS device 100 being configured as an environmental barrier structure acts as an environmental barrier for protecting the MEMS microphone sound transducer membrane 310 from moisture and/or environmental particles.

The MEMS device 100 being configured as an environmental barrier structure comprises a horizontally extending environmental barrier membrane or mesh structure. In this non-limiting example, the innovative membrane structure 130 may be configured as the aforementioned environmental barrier membrane or mesh structure.

The membrane structure 130, e.g., environmental barrier membrane or mesh structure, comprises the upright nanostructures 150 as discussed herein. This provides for an improved hydrophobicity / omniphobicity level of the membrane structure 130. Thus, intruding liquids and or any solid matter (like salts, particles, and other contaminants) contained in said liquids may be repelled from the surface of the membrane structure 130. This provides for a superior protection of the downstream arranged microphone membrane 310.

In the previous sections, different embodiments of the MEMS device 100 were described. In the following, examples and embodiments of methods for manufacturing a MEMS device 100 will be discussed.

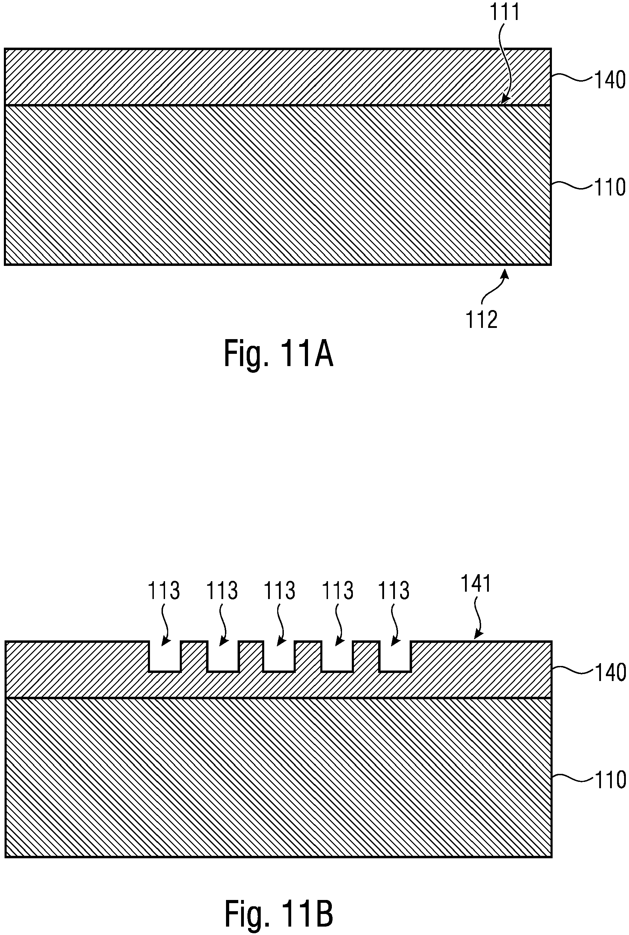

Figures 11A to 11F show a first embodiment of a method for fabricating a MEMS device 100 as discussed herein. As shown in Figure 11A, a substrate 110 is provided, the substrate 110 comprising a first substrate surface 111 and an opposite second substrate surface 112. The substrate 110 may comprise or consist of silicon. A sacrificial layer 140 may be arranged at the first substrate surface 111. The sacrificial layer 140 may comprise or consist of tetraethoxysilane (TEOS). Alternatively, the sacrificial layer 140 may comprise or consist of one or more oxides.

As shown in Figure 11B, the sacrificial layer 140 may be structured / patterned, e.g., by using a lithography process. In particular, so-called nanoimprints 113 may be structured into the sacrificial layer 140. The nanoimprints 113 may be structured into an upper surface 141 of the sacrificial layer 140, i.e., into a surface of the sacrificial layer 140 that faces away from the substrate 110.

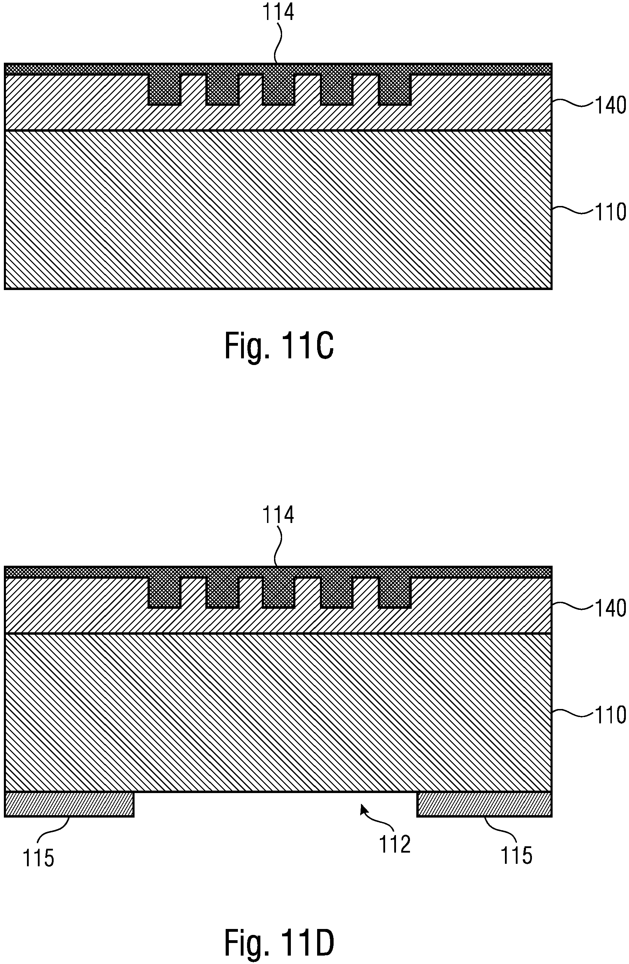

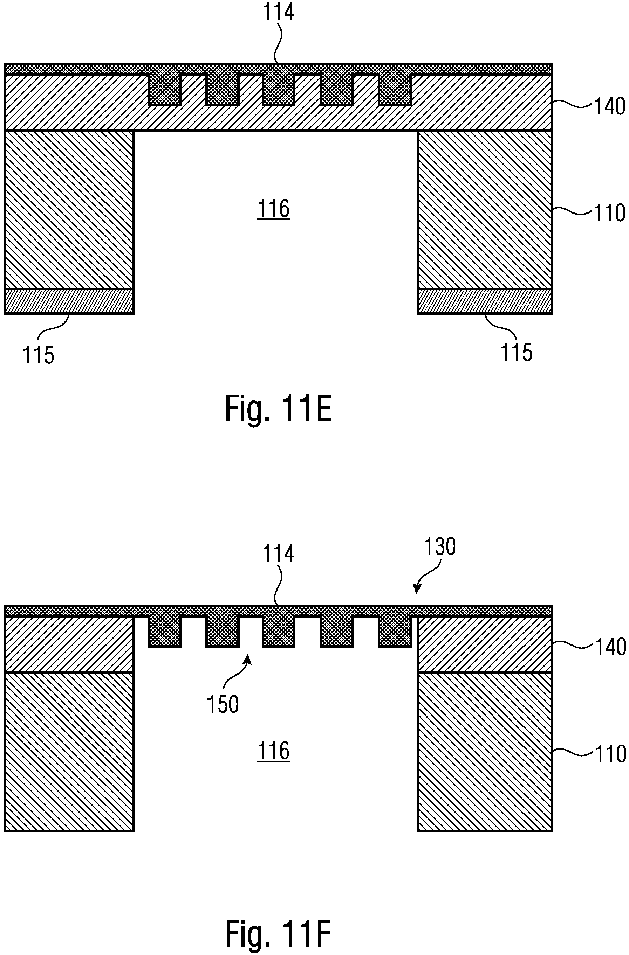

Figure 11C shows a further method step in which the nanoimprints 113 are filled with a first material 114, e.g., by using a deposition process, in which the first material 114 is deposited onto the structured sacrificial layer 140. The first material 114 may later form the membrane structure 130 with integrated nanostructures 150 (c.f. Fig. 11F). The first material 114 may comprise or consist of a CMOS-compatible material (CMOS: Complementary Metal-Oxide-Semiconductor). For example, the first material 114 may comprise or consist of at least one of (poly-)silicon, silicon nitride (Si₃N₄), carbon, polymers and metals.

Figure 11D shows a further method step, wherein a photoresist 115 is applied to the second surface 112 of the substrate 110. The photoresist 115 provides a negative form for a cavity 116 that is created in the next step, as shown in Figure 11E. A portion of the second substrate surface 112 that is located opposite to the filled nanoimprints 113 remains uncovered, i.e., it is not covered with the photoresist 115.

Figure 11E shows a further method step, in which the cavity 116 is structured into substrate 110. The cavity 116 is structured into that portion of the second substrate surface 112 that is not covered by the photoresist 115. The cavity 116 is structured through the entire substrate 110 until reaching the sacrificial layer 140. For example, the cavity 116 may be structured into the substrate 110 by using reactive ion etching (RIE). In result, the created cavity 116 is positioned opposite to the filled nanoimprints 113, and the created cavity 116 extends between the second substrate surface 112 and the sacrificial layer 140.

Figure 11F shows a further method step, in which the filled nanoimprints 113 are released by selectively removing the sacrificial layer 140 through the cavity 116. For example, a RIE or wet chemical etching process may be used for selectively removing portions of the sacrificial layer 140 that are located inside the cavity 116. In result, the cavity 116 becomes the above discussed through hole 120, and the (meanwhile released) first material 114 forms a horizontally extending membrane structure 130. Any of the first material 114 that was previously filled inside the (meanwhile released) nanoimprints 113 form upright (e.g., vertically extending) nanostructures 150 as discussed above. Since the horizontally extending membrane structure 130 and the upright (e.g., vertically extending) nanostructures 150 are made from the same (first) material 114, the membrane structure 130 and the nanostructures 150 are integrally formed. Furthermore, the nanostructures 150 may face and extend into the cavity 116.

Accordingly, the nanoimprints 113 (c.f. Figure 11B) may provide a negative form for the nanostructures 150 (c.f. Figure 11F). Thus, it is preferable that the diameter, pitch and aspect ratio of the nanoimprints 113 correspond to the desired diameter, pitch and aspect ratio of the nanostructures 150 in order to provide the desired (super-)hydrophobic / omniphobic surface characteristics.

With the method as described with reference to Figures 11A to 11F, the horizontally extending membrane structure 130 and the upright nanostructures 150 may be made from the same (first) material 114. In some examples, the first material 114 forming the membrane structure 130 and the integrally formed nanostructures 150 may comprise a conducting or semiconducting characteristic. For example, the first material 114 may comprise or consist of (poly-)silicon.

In some further examples, the first material 114 forming the membrane structure 130 and the integrally formed nanostructures 150 may comprise a dielectric characteristic. For example, the first material 114 may comprise or consist of silicon nitride or one or more oxides. Dielectric nanostructures 150 may be beneficial if electrical leakages shall be avoided.

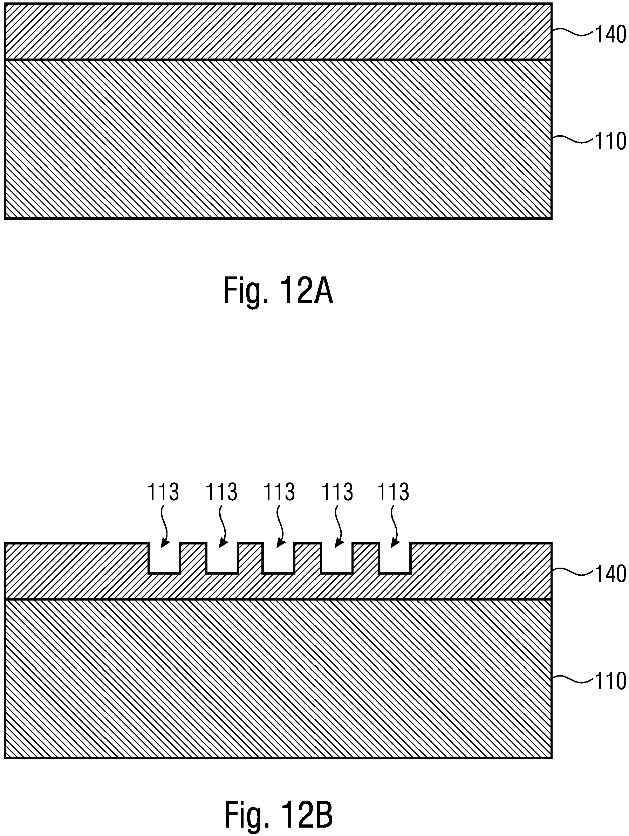

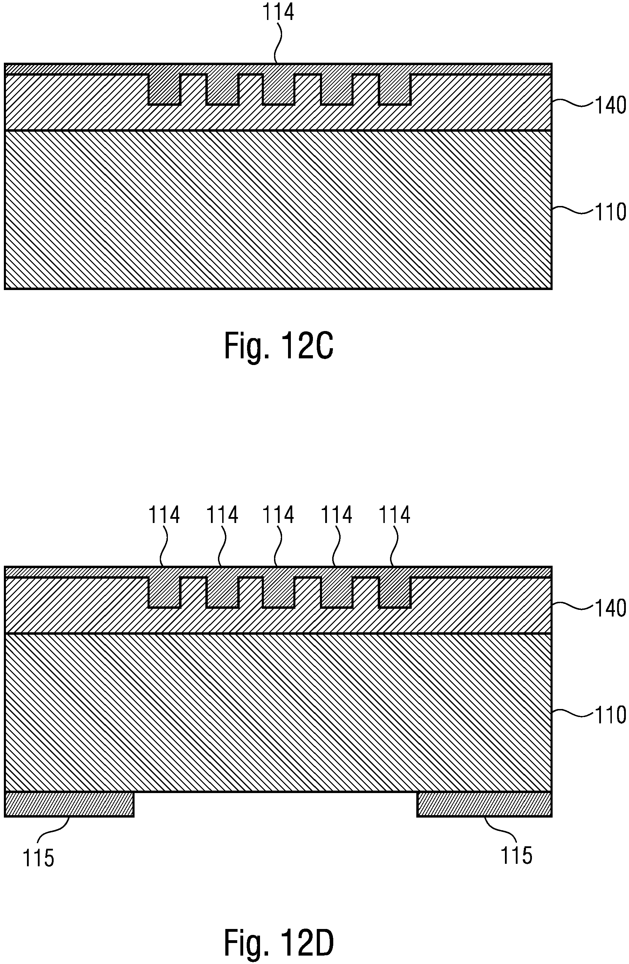

Figures 12A to 12F show an alternative method for fabricating a MEMS device 100. Like elements with like features, as discussed with reference to Figures 11A to 11F, are indicated with same reference numerals. Accordingly, for further details it is referred to the above discussion. A difference compared to the above discussed embodiment starts at Figure 12D. Here, the deposited first material 114 is removed from the sacrificial layer 140, while the deposited first material 114 residing inside the nanoimprints 113 is maintained. Accordingly, only the first material 114 that resides inside the nanoimprints 113 remains after this process step. In other words, the nanoimprints 113 being filled with the first material 114 remain, while the rest of the first material 114 is removed.

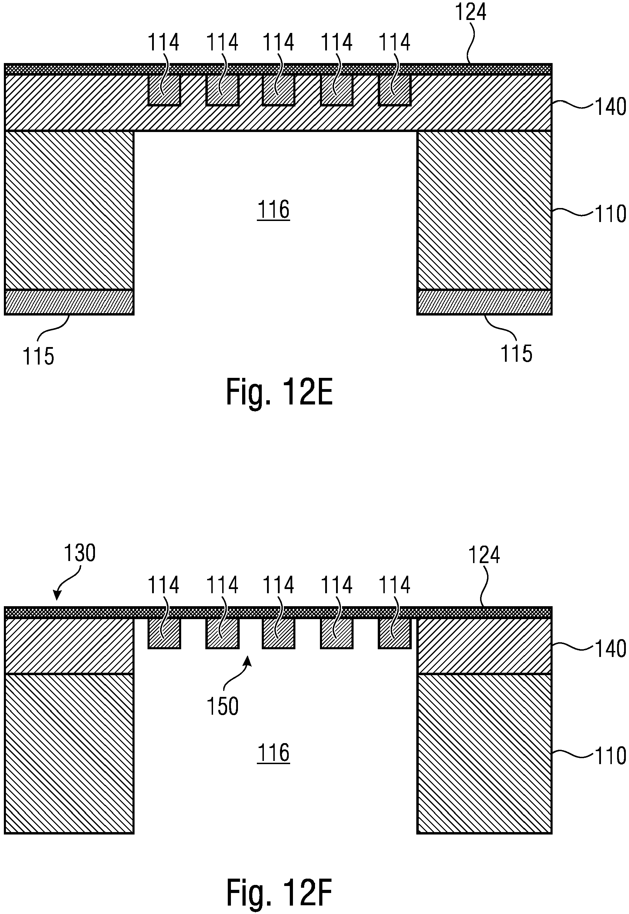

Figure 12E shows a further method step, wherein a different second material 124 is deposited onto the sacrificial layer 140 including the filled nanoimprints 113. The first material 114 residing inside the nanoimprints 113 and the deposited second material 124 may combine and/or adhere to each other. Furthermore, a cavity 116 may be structured into substrate 110, in the way as described above with reference to Figure 11E.

Figure 12F shows a further method step, in which the nanoimprints 113 being filled with the first material 114 and the deposited layer of the second material 124 are released by selectively removing the sacrificial layer 140 through the cavity 116. For example, a RIE process may be used for selectively removing portions of the sacrificial layer 140 that are located inside the cavity 116. In result, the cavity 116 becomes the above discussed through hole 120, and the (meanwhile released) second material 124 forms a horizontally extending membrane structure 130. Any of the first material 114 that was previously filled inside the (meanwhile released) nanoimprints 113 form upright (e.g., vertically extending) nanostructures 150 as discussed above.

Accordingly, the horizontally extending membrane structure 130 is made from the subsequently deposited second material 124, and the upright nanostructures 150 are made from the first material 114. The membrane structure 130 and the nanostructures 150 may be firmly bonded. Furthermore, the nanostructures 150 may face and extend into the cavity 116.

In some examples, the second material 124 forming the membrane structure 130 may comprise a conducting or semiconducting characteristic. For example, the second material 124 may comprise or consist of (poly-)silicon. The first material 114 forming the nanostructures 150 may comprise a dielectric characteristic. For example, the first material 114 may comprise or consist of silicon nitride (Si₃N₄) or one or more oxides. Dielectric nanostructures 150 may be beneficial if electrical leakages shall be avoided.

Accordingly, with the method as described with reference to Figures 12A to 12F, the horizontally extending membrane structure 130 and the upright (e.g., vertically extending) nanostructures 150 may be made from different materials. For example, a (semi-)conducting membrane structure 130 may be provided, which comprises dielectric nanostructures 150.

The above embodiments concern methods for creating a horizontally extending membrane structure 130 with upright (e.g., vertically extending) nanostructures 150, wherein said nanostructures 150 faced the cavity 116. In the following, some further embodiments will be described which provide for a method for creating a horizontally extending membrane structure 130 with upright (e.g., vertically extending) nanostructures 150, wherein said nanostructures 150 face away from the cavity 116. It is to be noted that these embodiments may be combined with each other, e.g., for creating a first set of nanostructures 150 facing the cavity 116 in combination with a second set of nanostructures 150 facing away from the cavity 116.

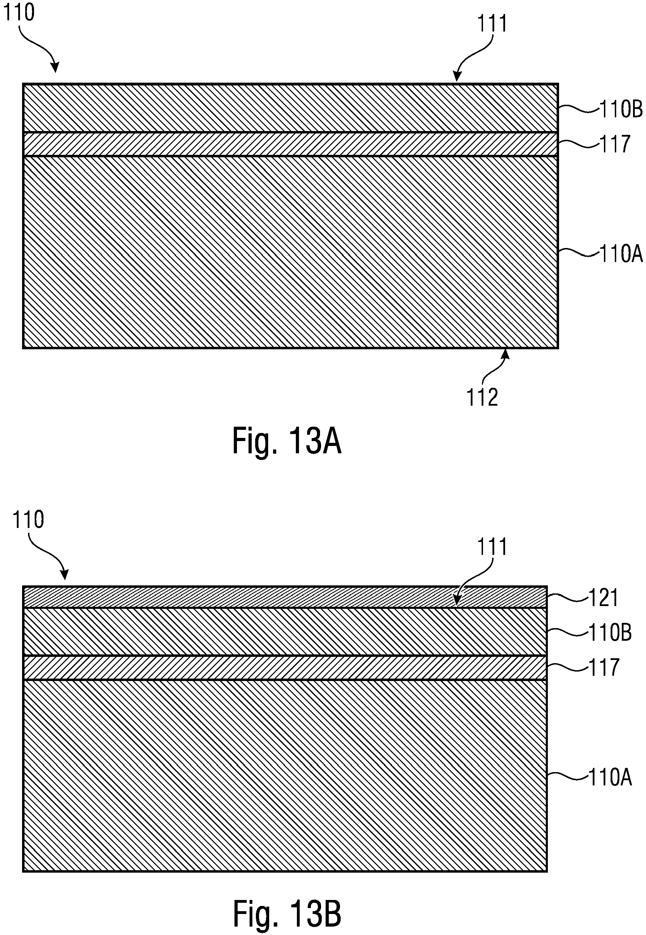

Figures 13A to 13J show an embodiment for creating nanostructures 150 according to a top-down approach. Like elements with like features, as discussed with reference to Figures 11A to 11F or 12A to 12F, are indicated with same reference numerals. Accordingly, for further details it is referred to the above discussion.

In Figure 13A, a substrate 110 is provided having a first substrate surface 111 and an opposite second substrate surface 112. The substrate 110 may comprise or consist of silicon. In this non-limiting example, a silicon-on-insulator (SOI) substrate is shown, which may comprise an insulating layer 117. However, the insulating layer 117 is optional. The insulating layer 117 may comprise or consist of one or more oxides, for example silicon oxide (SiO₂). The insulating layer 117 may divide the substrate 110 into a first substrate portion 110A and a second substrate portion 110B.

Figure 13B shows a further method step, wherein a material layer 121 is deposited onto the first substrate surface 111. The material layer 121 may comprise or consist of tetraethoxysilane (TEOS). Alternatively, the material layer 121 may comprise or consist of one or more oxides.

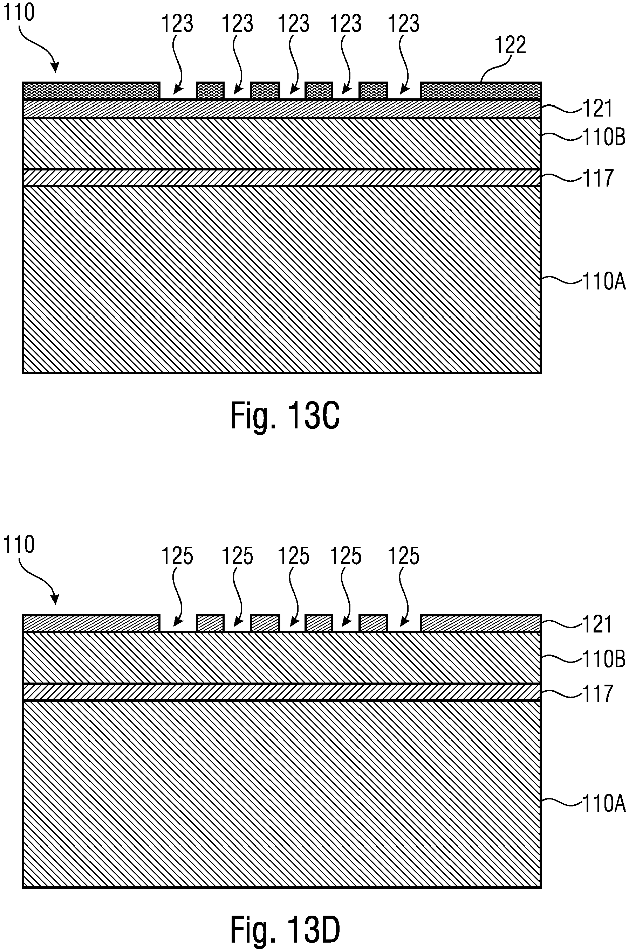

Figure 13C shows a further method step, wherein a thin photoresist 122 is applied onto the material layer 121. The photoresist 122 may be nanopatterned for creating a pattern with a plurality of openings 123 having dimensions in the range of nanometers. The nanopatterned photoresist 122 may provide a negative form for patterning the adjacent material layer 121 underneath.

Figure 13D shows a further method step, wherein the material layer 121 is patterned by means of the photoresist 122. Accordingly, the nanopattern of the photoresist 122 is transferred to the material layer 121 such that the material layer 121 comprises a pattern with a plurality of openings 125 having dimensions in the range of nanometers.

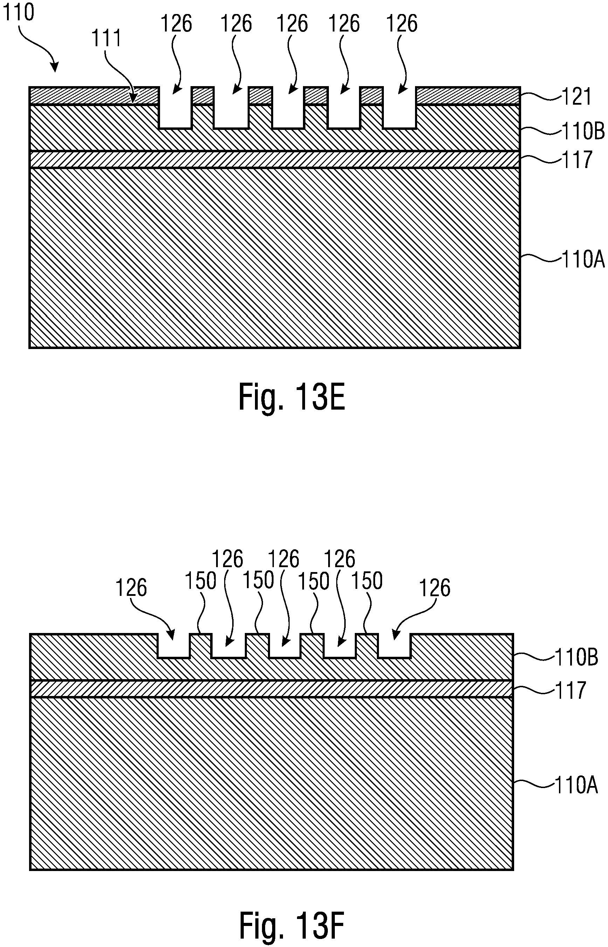

Figure 13E shows a further method step, wherein the first substrate surface 111 is structured using the nanopatterned material layer 121 as a mask. Vertical openings 126 are structured into the first substrate surface 111, e.g., by using a RIE process. The openings 126 may extend vertically into the substrate 110. The openings 126 may comprise dimensions in the range of nanometers.

Figure 13F shows a further method step, wherein the material layer 121 is removed from the substrate 110. The first substrate surface 111 is structured as described above, i.e., it comprises a pattern with a plurality of openings 126 having dimensions in the range of nanometers. Substrate material remaining laterally between adjacent openings 126 forms upright (e.g., vertically extending) nanostructures 150.

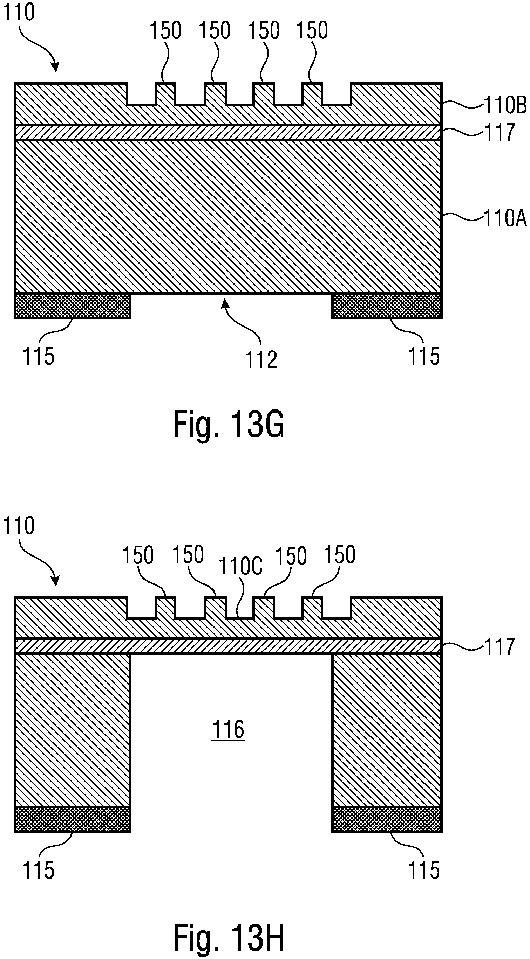

Figure 13G shows a further method step, wherein a thick negative photoresist 115 is applied to the second substrate surface 112. The photoresist 115 provides a negative form for a cavity 116 that is created in the next step, as shown in Figure 13H. A portion of the second substrate surface 112 that is located opposite to the upright nanostructures 150 remains uncovered, i.e., it is not covered with the photoresist 115.

Figure 13H shows a further method step, in which the cavity 116 is structured into substrate 110. The cavity 116 is structured into that portion of the second substrate surface 112 that is not covered with the photoresist 115. Accordingly, the cavity 116 is positioned opposite to the upright nanostructures 150.

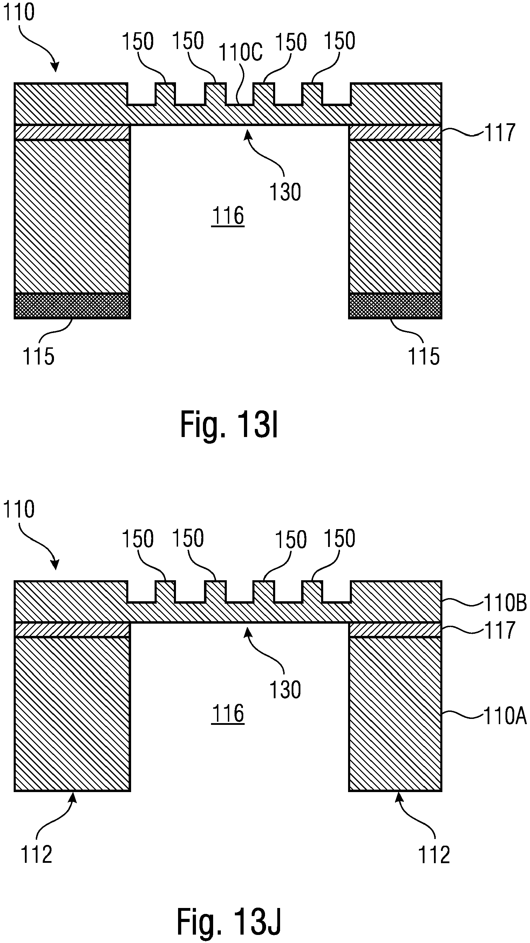

The cavity 116 is not structured through the entire substrate 110. Instead, the cavity 116 is structured such that it stops before reaching the nanostructures 150. Accordingly, a substrate portion 110C between the nanostructures 150 and the cavity 116 remains. This remaining substrate portion 110C may later form the horizontally extending membrane structure (c.f. Figure 13J). The remaining substrate portion 110C may comprise a thickness of only a few nanometers (e.g., between 300 nm and 1.100 nm).

As mentioned above, the substrate 110 may comprise an optional etch stop layer 117. If the etch stop layer 117 is available, as exemplarily depicted in Figures 13H, the cavity 116 may be structured until reaching the etch stop layer 117. However, if the etch stop layer 117 is not available, the structuring process of creating the cavity 116 may be precisely controlled such that the above mentioned substrate portion 110C remains between the cavity 116 and the nanostructures 150.

Figure 13I shows a further optional method step, wherein the optional etch stop layer 117 is removed inside the cavity 116 for releasing the above discussed remaining substrate portion 110C. Thus, the remaining substrate portion 110C forms the horizontally extending membrane structure 130 comprising the upright nanostructures 150. Of course, if the optional etch stop layer 117 was not present, the remaining substrate portion 110C would not have to be released but it would already form the membrane structure 130 in the previous process step (Figure 13H). When the membrane structure 130 is created, the cavity 116 becomes the above mentioned through hole 120.

Figure 13J shows a further method step, wherein the thick negative photoresist 115 is removed from the second substrate surface 112.

As mentioned above, the substrate 110 may be divided into a first substrate portion 110A and a second substrate portion 110B. For example, at least the second substrate portion 110B may comprise or consist of a CMOS-compatible material, e.g., silicon, silicon carbide (SiC), gallium nitride (GaN), carbon, metals, polymers.

While Figures 13A to 13J showed a top-down approach, an alternative bottom-up approach for creating the upright nanostructures 150 will be described in the following with reference to Figures 14A to 14H.

The method steps as shown in Figures 14A to 14D substantially correspond to the method steps as discussed above with reference to Figures 13A to 13D. Accordingly, like elements with like features, as discussed with reference to Figures 13A to 13D, are indicated with same reference numerals. Thus, for further details it is referred to the above discussion.

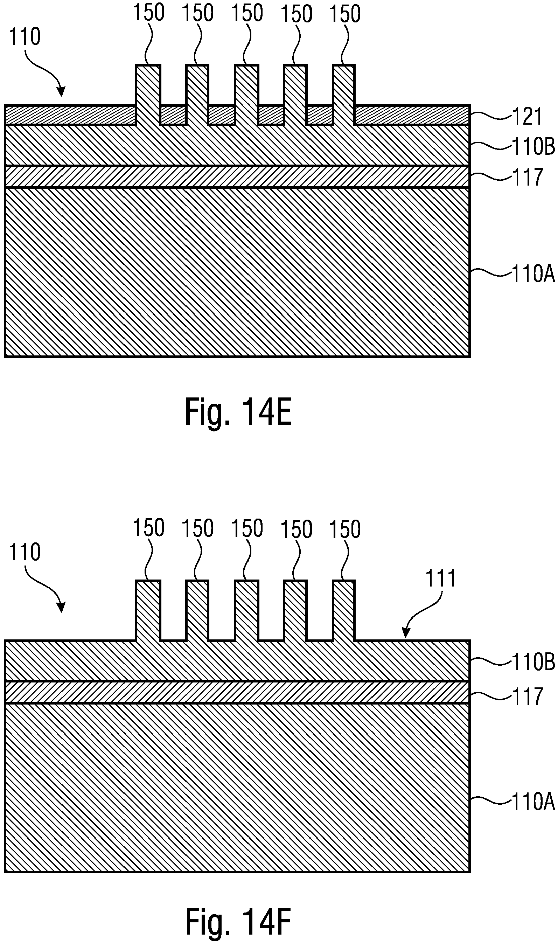

Figure 14E shows a method step, wherein upright nanostructures 150 are created at the first substrate surface 111, e.g., by growing. For example, the upright nanostructures 150 can be grown inside the openings 125 provided in the material layer 121 (c.f. Figure 14D). Alternatively, methods to bottom-up grow the silicon nanostructures 150 may include vapor-liquid-solid (VLS), solution-liquid-solid (SLS), and electrochemical methods.

Figure 14F shows a further method step, wherein the material layer 121 is removed such that only the upright nanostructures 150 may remain on the first substrate surface 111.

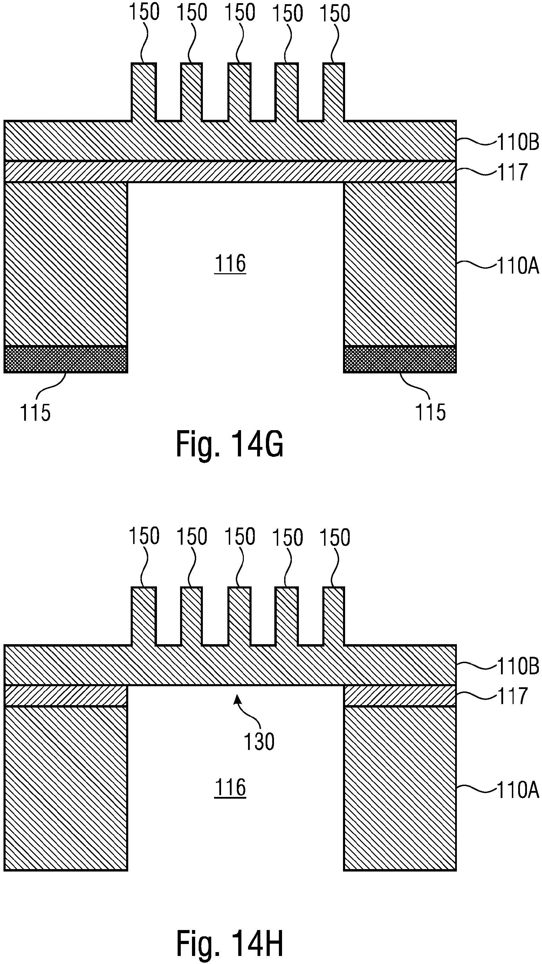

Then, the method step as shown in Figure 14G corresponds to the method step as previously discussed with reference to Figure 13H, and the method step as shown in Figure 14H corresponds to the method steps as previously discussed with reference to Figures 13I and 13J. Accordingly, like elements with like features are again indicated with same reference numerals, and for further details it is referred to the above discussion.

Summarizing, Figures 11A to 11F and Figures 12A to 12F showed method steps for creating nanostructures 150 that faced away from the cavity 116 or through hole 120, respectively. Figures 13A to 13J and Figures 14A to 14H showed method steps for creating nanostructures 150 that faced the cavity 116 or through hole 120, respectively.

Furthermore, in the method steps as shown in Figures 11A to 11F, Figures 12A to 12F and Figures 13A to 13J, the nanostructures 150 may be created in the first substrate surface 111 by structuring / patterning the substrate 110. In all of these embodiments, the substrate 110 may be structured / patterned by using photolithography or laser structuring. For example, the nanostructures 150 may be configured as so-called laser induced periodical structures (LIPSS) which may be created by femtosecond lasers. Additionally or alternatively, a direct laser interference patterning (DLIP) process may be used for creating the nanostructures 150 in the first substrate surface 111. Additionally or alternatively, a direct laser writing (DLW) process may be used for creating the nanostructures 150 in the first substrate surface 111.

In each embodiment discussed herein, the upright nanostructures 150 may be configured as three-dimensional structures, as exemplarily discussed above with reference to Figures 4, 5 and 6.

Summarizing, one of the core solutions of the herein described innovative concept is the provision of a nanostructured membrane and its applications on MEMS devices 100, like MEMS microphones and environmental barriers. The integrated nanostructures can result in (super)hydrophobic or omniphobic surface characteristics to repel incoming liquid droplets.

Parts of this disclosure concern design/concept and fabrication processes of upright (e.g., vertical) nanostructure arrays on membranes of MEMS microphones and environmental barriers. MEMS microphones and environmental barriers with integrated upright nanostructure arrays yield (super)omniphobic membrane surfaces.

For example, a MEMS microphone with a superomniphobic nanostructure array-integrated membrane comprises a high environmental robustness. The present innovative concept allows to provide MEMS microphones with integrated nanostructures either directly on the MEMS membrane or on a discrete environmental barrier.

The common approach to increase the environmental robustness of MEMS microphones is by integrating external environmental barriers made of polymer having hydrophobic and oleophobic characteristics into the package. The environmental barrier covering the sound port is located either inside (directly underneath the MEMS microphone) or outside the metal package lid (embedded on the structured printed circuit board (PCB)). Moreover, only SAMs deposited on planar Si surface might also result in hydrophobic characteristics. However, such organic materials are known to degrade within device operation time. Thus, instead of only using a chemical approach, the present concept combines physical and chemical methods into one (i.e., SAM/Si nanopillars) to reach higher environmental robustness.

The herein described innovative concept has, among others, the following advantages:
- Direct protection of the MEMS microphone chip
   ∘ Nanostructure arrays can be directly integrated into the MEMS device (e.g. underneath the bottom membrane of an SDM) and allow to directly protect it from the environment. This possibly allows to fabricate a MEMS microphone system that does not need additional environmental barrier components to achieve high water/oil-protection levels.
- Liquid repellent surface of MEMS membrane
   ∘ Compared to planar MEMS membrane, the nanostructure array-integrated MEMS membrane will provide (super)omniphobic surface that is able to repel the water/other liquids. Thus, it can also potentially provide self-cleaning feature because the approaching liquid droplets will bounce or roll off and simultaneously take the particles away from the membrane surface.
- Fabrication process of nanostructures adapted from existing technology
   ∘ Despite the required adjusted structure sizes and designs, currently existing technology can be used as a basis for the process development. Thus, the realization and optimization of the proposed upright nanostructures will not start from 'zero'. However, in terms of producing very small nanostructures (smaller than current MEMS bumps) and large-scale production (productive fabrication in front line), adaptations of lithography tools may be necessary.
- Flexible design related to combination with other organic or inorganic materials
   ∘ Silicon nanopillars can also be combined with either organic SAMs or other inorganic 1D nanostructures (e.g., ZnO nanowires) to increase the hydrophobicity/omniphobicity level of the membrane surfaces.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

While this disclosure has been described with reference to illustrative embodiments, this description is not intended to be construed in a limiting sense. Various modifications and combinations of the illustrative embodiments, as well as other embodiments of this disclosure, will be apparent to persons skilled in the art upon reference to the description. It is therefore intended that the appended claims encompass any such modifications or embodiments.

## Claims

1. A MEMS - microelectromechanical system - device (100) comprising:
a substrate (110) comprising a vertically extending through hole (120) and a horizontally extending membrane structure (130) covering the through hole (120),
wherein the membrane structure (130) comprises a plurality of upright nanostructures (150) for providing a liquid repellent membrane surface.

2. The MEMS device (100) according to claim 1,
wherein the upright nanostructures (150) are configured as three-dimensional geometric structures extending from the membrane structure (130), and extending into a direction away from the membrane structure (130).

3. The MEMS device (100) according to claim 1 or 2,
wherein the upright nanostructures (150) comprise at least one of:
• a diameter of ≤ 1 µm;
• a pitch, i.e., a distance between the centers of two adjacent nanostructures (150), said pitch comprising a ratio of at least pitch : diameter = 2:1;
• a width-to-height aspect ratio between 1:3 and 1:40.

4. The MEMS device (100) according to one of the preceding claims,
wherein the plurality of upright nanostructures (150) provided on the membrane structure (130) provides a membrane surface comprising at least one of a hydrophobic and an oleophobic surface characteristic.

5. The MEMS device (100) according to one of the preceding claims,
wherein the upright nanostructures (150) comprise at least one of the following geometrical shapes:
• a cylinder shape,
• a frustum cone shape,
• an inverted frustum cone shape,
• a T-shape, or
• a multifaceted T-shape.

6. The MEMS device (100) according to one of the preceding claims,
wherein the upright nanostructures (150) are coated with an organic Self Assembled Monolayer - SAM -.

7. The MEMS device (100) according to one of the preceding claims,
wherein the upright nanostructures (150) comprise inorganic nanodots (190) or nanowires (190) extending from an outer surface of the upright nanostructures (150).

8. The MEMS device (100) according to one of the preceding claims,
wherein the horizontally extending membrane structure (130) comprises a first membrane surface (130A) facing the through hole (120) and an opposite second membrane surface (130B) facing away from the through hole (120), and
wherein the upright nanostructures (150) are arranged on at least one of the first and second membrane surfaces (130A, 130B).

9. The MEMS device (100) according to one of the preceding claims,
wherein the MEMS device (100) is configured as a MEMS microphone, in which the horizontally extending membrane structure (130) is configured as a microphone sound transducer membrane, wherein the upright nanostructures (150) are arranged at the microphone sound transducer membrane.

10. The MEMS device (100) according to one of claims 1 to 8,
further comprising a MEMS microphone (300) comprising a microphone sound transducer membrane (310),
wherein the MEMS device (100) is configured as an environmental barrier structure comprising an environmental barrier membrane or mesh structure for protecting the microphone sound transducer membrane (310) from moisture and/or environmental particles, and
wherein the horizontally extending membrane structure (130), at which the upright nanostructures (150) are arranged, is configured as the environmental barrier membrane or mesh structure.

11. The MEMS device (100) according to one of claims 9 or 10,
wherein the MEMS microphone comprises a sound port (211) through which acoustic waves reach the membrane structure (130), and
wherein the membrane structure (130) is positioned such that the upright nanostructures (150) face the sound port (211).

12. The MEMS device (100) according to one of the preceding claims,
wherein the plurality of upright nanostructures (150) comprises an area density of 10⁶ - 10¹⁰ nanostructures per cm².

13. A method for fabricating a MEMS device (100), the method comprising:
providing a substrate (110) comprising a first substrate surface (111) and an opposite second substrate surface (112), wherein the substrate (110) comprises a sacrificial layer (140) arranged at the first substrate surface (111),
structuring nanoimprints (113) into the sacrificial layer (140),
filling the nanoimprints (113) by depositing a first material (114) onto the structured sacrificial layer (140),
structuring a cavity (116) into the substrate (110), the cavity (116) being positioned opposite to the filled nanoimprints (113) and extending between the second substrate surface (112) and the sacrificial layer (140), and
releasing the filled nanoimprints (113) by removing the sacrificial layer (140) through the cavity (116), thereby creating a horizontally extending membrane structure (130) comprising upright nanostructures (150) that extend into the cavity (116).

14. The method according to claim 13,
wherein the horizontally extending membrane (130) and the upright nanostructures (150) are made from the deposited first material (114).

15. The method according to claim 13,
wherein, after the step of depositing the first material (114) onto the structured sacrificial layer (140), the method further comprises steps of
removing the deposited first material (114) from the sacrificial layer (140) while maintaining the deposited first material (114) inside the filled nanoimprints (113), and
depositing a different second material (124) onto the sacrificial layer (140) and the filled nanoimprints (113), such that the horizontally extending membrane (130) is made from the deposited second material (124) while the upright nanostructures (150) are made from the first material (114).

16. A method for fabricating a MEMS device (100), the method comprising:
providing a substrate (110) having a first substrate surface (111) and an opposite second substrate surface (112),
creating upright nanostructures (150) in the first substrate surface (111),
structuring a cavity (116) into the substrate (110), the cavity (116) being positioned opposite to the upright nanostructures (150), and the cavity (116) extending from the second substrate surface (112) up to a remaining substrate portion (110C) between the cavity (116) and the upright nanostructures (150), thereby creating a membrane structure (130) horizontally extending over the cavity (116) and having the upright nanostructures (150) integrated therein, wherein the upright nanostructures (150) face away from the cavity (116).

17. The method according to claim 16,
wherein the step of creating the upright nanostructures (150) in the first substrate surface (111) comprises at least one of:
• structuring upright three-dimensional structures (150) into the first substrate surface using lithography, or
• growing upright three-dimensional structures on top of the first substrate surface, or
• structuring upright three-dimensional structures into the first substrate surface using laser structuring.

18. The method according to one of claims 13 to 17,
further comprising a step of applying a coating onto the upright nanostructures (150), the coating comprising an organic self-assembled monolayer.

19. The method according to one of claims 13 to 18,
further comprising a step of depositing a film of inorganic material onto the upright nanostructures (150) for forming inorganic nanoseeds, and
growing nanowires (190) from the deposited nanoseeds, such that the grown nanowires (190) extend from an outer surface of the upright nanostructures (150).
